# FASCICULE DE BREVET EUROPEEN

(11) **EP 3 319 917 B1**
(45) Date de publication et mention de la délivrance du brevet: **13.11.2024**
(21) Numéro de dépôt: 16742359.9
(22) Date de dépôt: 30.06.2016
(51) Int. Cl.: C03C 17/36

(54) **SUBSTRAT MUNI D'UN EMPILEMENT A PROPRIETES THERMIQUES**
SUBSTRAT MIT EINEM STAPEL MIT WÄRMEEIGENSCHAFTEN
SUBSTRATE PROVIDED WITH A STACK HAVING THERMAL PROPERTIES

(30) Priorité: 08.07.2015 FR 1556483
(43) Date de publication de la demande: 16.05.2018
(73) Titulaire: SAINT-GOBAIN GLASS FRANCE, 92400 Courbevoie (FR)
(72) Inventeur: LORENZZI, Jean Carlos, 75011 Paris (FR); GEORGES, Benoît, Dubai (AE)
(74) Mandataire: Saint-Gobain Recherche
(86) Numéro de dépôt international: PCT/FR2016/051653
(87) Numéro de publication internationale: WO 2017/006030

(56) Documents cités:
- WO-A1-2011/147864
- WO-A1-2014/177798
- CN-U- 202 175 621
- FR-A1- 2 985 724

## Description

L'invention concerne un matériau, tel qu'un vitrage, comprenant un substrat transparent revêtu d'un empilement de couches minces comprenant plusieurs couches fonctionnelles pouvant agir sur le rayonnement solaire et/ou le rayonnement infrarouge. L'invention concerne également les vitrages comprenant ces matériaux ainsi que l'utilisation de tels matériaux pour fabriquer des vitrages d'isolation thermique et/ou de protection solaire.

Ces vitrages peuvent être destinés aussi bien à équiper les bâtiments que les véhicules, en vue notamment de diminuer l'effort de climatisation et/ou d'empêcher une surchauffe excessive, vitrages dits « de contrôle solaire » et/ou diminuer la quantité d'énergie dissipée vers l'extérieur, vitrages dits « bas émissifs » entraînée par l'importance toujours croissante des surfaces vitrées dans les bâtiments et les habitacles de véhicules.

Selon les climats des pays où sont installés ces vitrages, les performances en termes de transmission lumineuse et de facteur solaire recherchées peuvent varier dans une certaine gamme. La transmission lumineuse doit être suffisamment faible pour supprimer l'éblouissement et suffisamment élevée pour que la diminution de la quantité de lumière pénétrant à l'intérieur de l'espace délimité par ledit vitrage ne rende pas obligatoire l'utilisation de la lumière artificielle. Par exemple, dans les pays où les niveaux d'ensoleillement sont élevés, il existe une demande forte de vitrage présentant une transmission lumineuse de l'ordre de 50 % et des valeurs de facteur solaire suffisamment basses.

Des vitrages comprenant des substrats transparents revêtus d'un empilement de couches minces comprenant trois couches fonctionnelles métalliques, chacune disposée entre deux revêtements diélectriques ont été proposés afin d'améliorer la protection solaire tout en conservant une transmission lumineuse suffisante. Ces empilements sont généralement obtenus par une succession de dépôts effectués par pulvérisation cathodique éventuellement assistée par champ magnétique. Ces vitrages sont qualifiés de sélectifs car ils permettent :
- de diminuer la quantité d'énergie solaire pénétrant à l'intérieur des bâtiments en présentant un faible facteur solaire (FS ou g),
- de garantir une transmission lumineuse suffisante,
- de présenter une faible émissivité pour réduire la déperdition de chaleur par le rayonnement infrarouge de grande longueur d'onde.

Selon l'invention, on entend :
- facteur solaire « g », le rapport en pourcentage entre l'énergie totale entrant dans le local à travers le vitrage et l'énergie solaire incidente,
- sélectivité « s », le rapport entre la transmission lumineuse et le facteur solaire TL/g.

Les matériaux de l'art antérieur permettent d'obtenir des valeurs de transmission lumineuse, de facteur solaire et d'émissivité dans les gammes recherchées. Cependant, l'aspect esthétique et les propriétés en réflexion de tels vitrages ne donnent pas entière satisfaction et présentent notamment les inconvénients suivants :
- des couleurs en réflexion extérieure non neutres, et
- des niveaux de réflexion extérieure trop faible.

Enfin, il existe actuellement une forte demande pour des vitrages présentant un aspect argent brillant en réflexion extérieure.

Les matériaux actuellement sur le marché permettant d'obtenir cet aspect argent brillant en réflexion côté extérieure comprennent :
- des substrats revêtus d'empilements déposés par voie chimique (CVD),
- des substrats revêtus d'empilements déposés par pulvérisation cathodique comprenant des couches fonctionnelles qui ne sont pas à base d'argent mais par exemple à base de niobium.

Ces matériaux ne permettent pas d'obtenir les performances optiques et énergétiques recherchées. En effet, ces matériaux ne présentent pas à la fois un faible facteur solaire (FS ou g), une transmission lumineuse suffisante et une sélectivité élevée.

L'objectif de l'invention est de développer un matériau présentant à la fois un aspect argent brillant et des propriétés de contrôle solaire exceptionnelles. Selon l'invention, on cherche donc à minimiser le facteur solaire et à augmenter la sélectivité, tout en gardant une transmission lumineuse adaptée pour permettre une bonne isolation et une bonne vision.

La complexité des empilements comprenant trois couches fonctionnelles rend difficile l'amélioration de ces propriétés en réflexion sans nuire aux performances de contrôle solaire.

WO 2014/177798 A1 et CN202175621U divulguent des substrats revêtus comprenant trois couches métalliques fonctionnelles à base d'argent et quatre revêtements diélectriques.

Il existe donc un besoin de développer un vitrage permettant :
- de minimiser le facteur solaire,
- d'augmenter la réflexion côté extérieur pour notamment préserver l'intimité (effet « privacy »)
- d'obtenir en réflexion un aspect argent brillant pour l'esthétique,
- de garantir une transmission lumineuse adaptée pour permettre une bonne isolation et une bonne vision.

Le demandeur a découvert de manière surprenante qu'en optimisant les épaisseurs des trois couches fonctionnelles et en choisissant un revêtement diélectrique situé entre le substrat et la première couche fonctionnelle relativement épais, on obtient un matériau susceptible de présenter les propriétés recherchées. L'aspect brillant argent et une réflexion côté extérieur élevée peuvent notamment être obtenus.

La solution de l'invention représente un excellent compromis entre les performances optiques, thermiques, la transparence et l'aspect esthétique.

L'invention a pour objet un matériau comprenant un substrat transparent revêtu d'un empilement de couches minces comportant successivement à partir du substrat une alternance de trois couches métalliques fonctionnelles à base d'argent dénommées en partant du substrat première, deuxième et troisième couches fonctionnelles et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, caractérisé en ce que :
- l'épaisseur de la première couche fonctionnelle est inférieure à l'épaisseur de la deuxième couche fonctionnelle,
- l'épaisseur de la première couche fonctionnelle est inférieure à l'épaisseur de la troisième couche fonctionnelle,
- l'épaisseur de la troisième couche métallique fonctionnelle est comprise entre 13 et 18 nm,
- les revêtements diélectriques M1 et M2 ont chacun une épaisseur optique Eo1 et Eo2 satisfaisant la relation suivante : Eo2 < 1,1 Eo1, de préférence Eo2 < Eo1,
le matériau présente une transmission lumineuse inférieure à 60,0 % et une réflexion lumineuse côté extérieur supérieure ou égale à 20,0 %.

L'invention concerne également :
- le procédé d'obtention d'un matériau selon l'invention,
- le vitrage comprenant au moins un matériau selon l'invention,
- l'utilisation d'un vitrage selon l'invention en tant que vitrage de contrôle solaire pour le bâtiment ou les véhicules,
- un bâtiment ou un véhicule comprenant un vitrage selon l'invention.

En modulant les épaisseurs des couches fonctionnelles et des revêtements diélectriques, la transparence du vitrage peut être contrôlée de façon à obtenir des valeurs de TL de l'ordre de 50 %, gamme adaptée tout particulièrement pour les vitrages destinés à être utilisés dans des régions à fort ensoleillement. Mais l'avantage majeur de l'invention est que l'obtention de l'aspect visuel satisfaisant avec notamment des couleurs en réflexion extérieure particulières ainsi que des valeurs de réflexion extérieure suffisamment élevées ne s'opèrent pas au détriment des performances de protection solaire.

Les caractéristiques préférées qui figurent dans la suite de la description sont applicables aussi bien au procédé selon l'invention que, le cas échéant, aux produit, c'est-à-dire aux matériaux ou aux vitrages comprenant le matériau.

Toutes les caractéristiques lumineuses présentées dans la description sont obtenues selon les principes et méthodes décrits dans la norme européenne EN 410 se rapportant à la détermination des caractéristiques lumineuses et solaires des vitrages utilisés dans le verre pour la construction.

De manière conventionnelle, les indices de réfraction sont mesurés à une longueur d'onde de 550 nm. Les facteurs de transmission lumineuse TL et de réflexion lumineuse RL sont mesurés sous l'illuminant D65 avec un champ de vision de 2°.

Sauf indication contraire, toutes les valeurs et gammes de valeurs des caractéristiques optiques et thermiques sont données pour un vitrage double constitué d'un substrat de type verre sodo-calcique ordinaire de 6 mm portant l'empilement de couches minces, d'un espace intercalaire de 16 mm rempli d'argon à raison de 90 % et d'air à raison de 10 % et d'un autre substrat de type verre sodo-calcique, non-revêtu, d'une épaisseur de 4 mm. Le substrat revêtu est placé de sorte que l'empilement de couches minces se trouve en face 2 du vitrage. La réflexion extérieure Rext. est observée du côté du substrat comprenant l'empilement, tandis que la réflexion observée du côté du substrat ne comprenant pas l'empilement est désignée comme la réflexion intérieure. La transmission lumineuse (TL) des substrats de type verre sodo-calcique ordinaire, sans empilement est supérieure à 89 %, de préférence de 90 %.

Sauf mention contraire, les épaisseurs évoquées dans le présent document sans autres précisions sont des épaisseurs physiques, réelles ou géométriques dénommées Ep et sont exprimées en nanomètres (et non pas des épaisseurs optiques). L'épaisseur optique Eo est définie comme l'épaisseur physique de la couche considérée multipliée par son indice de réfraction (n) à la longueur d'onde de 550 nm : Eo = n*Ep. L'indice de réfraction étant une valeur adimensionnelle, on peut considérer que l'unité de l'épaisseur optique est celle choisie pour l'épaisseur physique.

Si un revêtement diélectrique est composé de plusieurs couches diélectriques, l'épaisseur optique du revêtement diélectrique correspond à la somme des épaisseurs optiques des différentes couches diélectriques constituant le revêtement diélectrique.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur » est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une (ou plusieurs) couche(s) intercalée(s) entre ces deux couches (ou couche et revêtement).

Au sens de la présente invention, les qualifications « première », « deuxième », « troisième » et « quatrième » pour les couches fonctionnelles ou les revêtements diélectriques sont définies en partant du substrat porteur de l'empilement et en se référant aux couches ou revêtements de même fonction. Par exemple, la couche fonctionnelle la plus proche du substrat est la première couche fonctionnelle, la suivante en s'éloignant du substrat est la deuxième couche fonctionnelle, etc.

L'invention concerne également un vitrage comprenant un matériau selon l'invention. De manière conventionnelle, les faces d'un vitrage sont désignées à partir de l'extérieur du bâtiment et en numérotant les faces des substrats de l'extérieur vers l'intérieur de l'habitacle ou du local qu'il équipe. Cela signifie que la lumière solaire incidente traverse les faces dans l'ordre croissant de leur numéro.

L'empilement est de préférence positionné dans le vitrage de sorte que la lumière incidente provenant de l'extérieur traverse le premier revêtement diélectrique avant de traverser la première couche métallique fonctionnelle. L'empilement n'est pas déposé sur la face du substrat définissant la paroi extérieure du vitrage mais sur la face intérieure de ce substrat. L'empilement est donc avantageusement positionné en face 2, la face 1 du vitrage étant la face la plus à l'extérieur du vitrage, comme habituellement.

En choisissant de monter de cette façon le vitrage, le premier revêtement diélectrique (M1) relativement épais est situé entre l'extérieur et toutes les couches fonctionnelles à base d'argent de l'empilement. Il semble de manière surprenante, qu'un tel revêtement, placé à cet endroit permet d'obtenir la combinaison des propriétés recherchées et notamment une réflexion élevée et un aspect argent brillant côté extérieur tout en maintenant les excellentes performances énergétiques et sans nécessiter de modifications substantielles des autres paramètres de l'empilement tels que la nature, l'épaisseur et la séquence des couches le constituant.

De préférence, l'empilement est déposé par pulvérisation cathodique assistée par un champ magnétique (procédé magnétron). Selon ce mode de réalisation avantageux, toutes les couches de l'empilement sont déposées par pulvérisation cathodique assistée par un champ magnétique.

L'invention concerne également le procédé d'obtention d'un matériau selon l'invention, dans lequel on dépose les couches de l'empilement par pulvérisation cathodique magnétron.

Les couches fonctionnelles métalliques à base d'argent comprennent au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche métallique fonctionnelle à base d'argent.

Selon des modes de réalisation avantageux de l'invention, les couches métalliques fonctionnelles satisfont une ou plusieurs des conditions suivantes :
- les trois couches métalliques fonctionnelles correspondent à la première, à la deuxième et à la troisième couche fonctionnelle métallique définies en partant du substrat,
- le rapport de l'épaisseur de la troisième couche métallique fonctionnelle sur l'épaisseur de la deuxième couche fonctionnelle est compris entre 0,90 et 1,10 en incluant ces valeurs, de préférence 0,95 et 1,05, et/ou
- le rapport de l'épaisseur de la troisième couche métallique fonctionnelle sur l'épaisseur de la deuxième couche fonctionnelle est inférieur à 1,0, de préférence inférieur à 0,99, et/ou
- l'épaisseur de la première couche métallique fonctionnelle est, par ordre de préférence croissant, comprise entre 6 et 12 nm, entre 7 et 11 nm, entre 8 et 10 nm, et/ou
- l'épaisseur de la deuxième couche fonctionnelle est supérieure à 15 nm, et/ou
- l'épaisseur de la deuxième couche métallique fonctionnelle est, par ordre de préférence croissant, comprise entre 13 et 20 nm, entre 14 et 18 nm, entre 15 et 17 nm, et/ou
- l'épaisseur de la troisième couche métallique fonctionnelle est, par ordre de préférence croissant, comprise entre 13 et 18 nm, entre 14 et 18 nm, entre 15 et 17 nm.

Ces plages d'épaisseur pour les couches métalliques fonctionnelles sont les plages pour lesquelles les meilleurs résultats sont obtenus pour une transmission lumineuse en double vitrage d'environ 50 %, une réflexion lumineuse élevée et un facteur solaire bas. On obtient ainsi une sélectivité élevée.

Le vitrage présente une transmission lumineuse inférieure à 60,0 % et une réflexion lumineuse côté extérieur supérieure ou égale à 20,0 %.

L'empilement peut comprendre en outre au moins une couche de blocage située au contact d'une couche fonctionnelle.

Les couches de blocage ont traditionnellement pour fonction de protéger les couches fonctionnelles d'une éventuelle dégradation lors du dépôt du revêtement antireflet supérieur et lors d'un éventuel traitement thermique à haute température, du type recuit, bombage et/ou trempe.

Les couches de blocage sont choisies parmi les couches métalliques à base d'un métal ou d'un alliage métallique, les couches de nitrure métallique, les couches d'oxyde métallique et les couches d'oxynitrure métallique d'un ou plusieurs éléments choisis parmi le titane, le nickel, le chrome et le niobium telles que Ti, TiN, TiOx, Nb, NbN, Ni, NiN, Cr, CrN, NiCr, NiCrN. Lorsque ces couches de blocage sont déposées sous forme métallique, nitrurée ou oxynitrurée, ces couches peuvent subir une oxydation partielle ou totale selon leur épaisseur et la nature des couches qui les entourent, par exemple, au moment du dépôt de la couche suivante ou par oxydation au contact de la couche sous-jacente.

Selon des modes de réalisation avantageux de l'invention, la ou les couches de blocage satisfont une ou plusieurs des conditions suivantes :
- chaque couche métallique fonctionnelle est au contact d'au moins une couche de blocage choisie parmi une sous-couche de blocage et une surcouche de blocage, et/ou
- l'épaisseur de chaque couche de blocage est d'au moins 0,1 nm, de préférence comprise entre 0,1 et 1,0 nm, et/ou
- l'épaisseur totale de toutes les couches de blocage au contact des couches fonctionnelles est comprise entre 0,1 et 2 nm en incluant ces valeurs, de préférence entre 0,3 et 1,5 nm, voire 0,5 et 1,0 nm.

Selon des modes de réalisation avantageux de l'invention, les revêtements diélectriques satisfont une ou plusieurs des conditions suivantes en termes d'épaisseurs :
- l'épaisseur optique du premier revêtement diélectrique M1 est, par ordre de préférence croissant, comprise de 85 à 150 nm, de 100 à 145 nm, de 110 à 140 nm, et/ou
- l'épaisseur physique du premier revêtement diélectrique M1 est, par ordre de préférence croissant, comprise de 40 à 80 nm, de 50 à 75 nm, de 55 à 70 nm, et/ou
- l'épaisseur optique du deuxième revêtement diélectrique M2 est, par ordre de préférence croissant, comprise de 80 à 150 nm, de 90 à 145 nm, de 100 à 135 nm, et/ou
- l'épaisseur physique du deuxième revêtement diélectrique M2 est, par ordre de préférence, croissant comprise de 40 à 80 nm, de 50 à 75 nm, de 55 à 70 nm, et/ou
- l'épaisseur optique du troisième revêtement diélectrique M3 est, par ordre de préférence croissant, comprise de 135 à 220 nm, de 150 à 210 nm, de 160 à 200 nm, et/ou
- l'épaisseur physique du troisième revêtement diélectrique M3 est, par ordre de préférence croissant, comprise de 60 à 110 nm, de 70 à 105 nm, de 80 à 100 nm, et/ou
- l'épaisseur optique du quatrième revêtement diélectrique M4 est, par ordre de préférence croissant, comprise de 65 à 120 nm, de 75 à 110 nm, de 85 à 105 nm, et/ou
- l'épaisseur physique du quatrième revêtement diélectrique M4 est, par ordre de préférence croissant, comprise de 30 à 60 nm, de 35 à 55 nm, de 40 à 50 nm.

Selon des modes de réalisation avantageux de l'invention, les revêtements diélectriques satisfont une ou plusieurs des conditions suivantes :
- les revêtements diélectriques comprennent au moins une couche diélectrique à base d'oxyde ou de nitrure d'un ou plusieurs éléments choisis parmi le silicium, le titane, le zirconium, l'aluminium, l'étain, le zinc, et/ou
- au moins un revêtement diélectrique comporte au moins une couche diélectrique à fonction barrière, et/ou
- chaque des revêtement diélectrique comporte au moins une couche diélectrique à fonction barrière, et/ou
- les couches diélectriques à fonction barrière sont à base de composés de silicium et/ou d'aluminium choisis parmi les oxydes tels que SiO₂ et Al₂O₃, les nitrures de silicium Si₃N₄ et AIN et les oxynitures SiOₓN_{y} et AlOₓN_{y}. et/ou
- les couches diélectriques à fonction barrière sont à base de composés de silicium et/ou d'aluminium comprennent éventuellement au moins un autre élément, comme l'aluminium, le hafnium et le zirconium, et/ou
- au moins un revêtement diélectrique comprend au moins une couche diélectrique à fonction stabilisante, et/ou
- chaque revêtement diélectrique comprend au moins une couche diélectrique à fonction stabilisante, et/ou
- les couches diélectriques à fonction stabilisante sont de préférence à base d'oxyde choisi parmi l'oxyde de zinc, l'oxyde d'étain, l'oxyde de zirconium ou un mélange d'au moins deux d'entre eux,
- les couches diélectriques à fonction stabilisante sont de préférence à base d'oxyde cristallisé, notamment à base d'oxyde de zinc, éventuellement dopé à l'aide d'au moins un autre élément, comme l'aluminium, et/ou
- chaque couche fonctionnelle est au-dessus d'un revêtement diélectrique dont la couche supérieure est une couche diélectrique à fonction stabilisante, de préférence à base d'oxyde de zinc et/ou en-dessous d'un revêtement diélectrique dont la couche inférieure est une couche diélectrique à fonction stabilisante, de préférence à base d'oxyde de zinc.

De préférence, chaque revêtement diélectrique est constitué uniquement d'une ou de plusieurs couches diélectriques. De préférence, il n'y a donc pas de couche absorbante dans les revêtements diélectriques afin de ne pas diminuer la transmission lumineuse.

Les empilements de l'invention peuvent comprendre des couches diélectriques à fonction barrière. On entend par couches diélectriques à fonction barrière, une couche en un matériau apte à faire barrière à la diffusion de l'oxygène et de l'eau à haute température, provenant de l'atmosphère ambiante ou du substrat transparent, vers la couche fonctionnelle. Les matériaux constitutifs de la couche diélectrique à fonction barrière ne doivent donc pas subir de modification chimique ou structurelle à haute température qui entraînerait une modification de leurs propriétés optiques. La ou les couches à fonction barrière sont de préférence également choisies en un matériau apte à faire barrière au matériau constitutif de la couche fonctionnelle. Les couches diélectriques à fonction barrière permettent donc à l'empilement de subir sans évolution optique trop significative des traitements thermiques du type recuit, trempe ou bombage.

Les empilements de l'invention peuvent comprendre des couches diélectriques à fonction stabilisante. Au sens de l'invention, « stabilisante » signifie que l'on sélectionne la nature de la couche de façon à stabiliser l'interface entre la couche fonctionnelle et cette couche. Cette stabilisation conduit à renforcer l'adhérence de la couche fonctionnelle aux couches qui l'entourent, et de fait elle va s'opposer à la migration de son matériau constitutif.

La ou les couches diélectriques à fonction stabilisante peuvent se trouver directement au contact d'une couche fonctionnelle ou séparées par une couche de blocage.

De préférence, la dernière couche diélectrique de chaque revêtement diélectrique situé en-dessous d'une couche fonctionnelle est une couche diélectrique à fonction stabilisante. En effet, il est avantageux d'avoir une couche à fonction stabilisante, par exemple, à base d'oxyde de zinc en-dessous d'une couche fonctionnelle, car elle facilite l'adhésion et la cristallisation de la couche fonctionnelle à base d'argent et augmente sa qualité et sa stabilité à haute température.

Il est également avantageux d'avoir une couche fonction stabilisante, par exemple, à base d'oxyde de zinc au-dessus d'une couche fonctionnelle, pour en augmenter l'adhésion et s'opposer de manière optimale à la diffusion du côté de l'empilement opposé au substrat.

La ou les couches diélectriques à fonction stabilisante peuvent donc se trouver au-dessus et/ou en dessous d'au moins une couche fonctionnelle ou de chaque couche fonctionnelle, soit directement à son contact ou soit séparées par une couche de blocage.

Avantageusement, chaque couche diélectrique à fonction barrière est séparée d'une couche fonctionnelle par au moins une couche diélectrique à fonction stabilisante.

Cette couche diélectrique à fonction stabilisante peut avoir une épaisseur d'au moins 4 nm, notamment une épaisseur comprise entre 4 et 10 nm et mieux de 8 à 10 nm.

L'empilement de couches minces peut éventuellement comprendre une couche de protection. La couche de protection est de préférence la dernière couche de l'empilement, c'est-à-dire la couche la plus éloignée du substrat revêtu de l'empilement. Ces couches supérieures de protection sont considérées comme comprises dans le quatrième revêtement diélectrique. Ces couches ont en général une épaisseur comprise entre 2 et 10 nm, de préférence 2 et 5 nm. Cette couche de protection peut être choisie parmi une couche de titane, de zirconium, d'hafnium, de zinc et/ou d'étain, ce ou ces métaux étant sous forme métallique, oxydée ou nitrurée.

La couche de protection peut par exemple être choisie parmi une couche d'oxyde de titane, une couche d'oxyde de zinc et d'étain ou une couche d'oxyde de titane et de zirconium.

Un mode de réalisation particulièrement avantageux concerne un substrat revêtu d'un empilement défini en partant du substrat transparent comprenant :
- un premier revêtement diélectrique comprenant au moins une couche diélectrique à fonction barrière et une couche diélectrique à fonction stabilisante,
- éventuellement une couche de blocage,
- une première couche fonctionnelle,
- éventuellement une couche de blocage,
- un deuxième revêtement diélectrique comprenant au moins un couche diélectrique à fonction stabilisante inférieure, une couche diélectrique à fonction barrière et une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins un couche diélectrique à fonction stabilisante inférieure, une couche diélectrique à fonction barrière et une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante et une couche diélectrique à fonction barrière et éventuellement une couche de protection.

Les substrats transparents selon l'invention sont de préférence en un matériau rigide minéral, comme en verre, ou organiques à base de polymères (ou en polymère).

Les substrats transparents organiques selon l'invention peuvent également être en polymère, rigides ou flexibles. Des exemples de polymères convenant selon l'invention comprennent, notamment :
- le polyéthylène,
- les polyesters tels que le polyéthylène téréphtalate (PET), le polybutylène téréphtalate (PBT), le polyéthylène naphtalate (PEN) ;
- les polyacrylates tels que le polyméthacrylate de méthyle (PMMA) ;
- les polycarbonates ;
- les polyuréthanes ;
- les polyamides ;
- les polyimides ;
- les polymères fluorés comme les fluoroesters tels que l'éthylène tétrafluoroéthylène (ETFE), le polyfluorure de vinylidène (PVDF), le polychlorotrifluorethylène (PCTFE), l'éthylène de chlorotrifluorethylène (ECTFE), les copolymères éthylène-propylène fluorés (FEP) ;
- les résines photoréticulables et/ou photopolymérisables, telles que les résines thiolène, polyuréthane, uréthane-acrylate, polyester-acrylate et
- les polythiouréthanes.

Le substrat est de préférence une feuille de verre ou de vitrocéramique.

Le substrat est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate.

Le substrat possède avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le matériau, c'est-à-dire le substrat revêtu de l'empilement, peut subir un traitement thermique à température élevée tel qu'un recuit, par exemple par un recuit flash tel qu'un recuit laser ou flammage, une trempe et/ou un bombage. La température du traitement thermique est supérieure à 400 °C, de préférence supérieure à 450 °C, et mieux supérieure à 500 °C. Le substrat revêtu de l'empilement peut donc être bombé et/ou trempé.

Le vitrage de l'invention peut être sous forme de vitrage monolithique, feuilleté ou multiple, en particulier double vitrage ou triple vitrage.

Dans le cas d'un vitrage monolithique ou multiple, l'empilement est de préférence déposé en face 2, c'est-à-dire qu'il se trouve sur le substrat définissant la paroi extérieure du vitrage et plus précisément sur la face intérieure de ce substrat.

Un vitrage monolithique comporte 2 faces, la face 1 est à l'extérieur du bâtiment et constitue donc la paroi extérieure du vitrage, la face 2 est à l'intérieur du bâtiment et constitue donc la paroi intérieure du vitrage.

Un vitrage multiple comprend au moins deux substrats maintenus à distance de manière à délimiter une cavité remplie par un gaz isolant. Les matériaux selon l'invention conviennent tout particulièrement lorsqu'ils sont utilisés dans des double-vitrages à isolation thermique renforcée (ITR).

Un double vitrage comporte 4 faces, la face 1 est à l'extérieur du bâtiment et constitue donc la paroi extérieure du vitrage, la face 4 est à l'intérieur du bâtiment et constitue donc la paroi intérieure du vitrage, les faces 2 et 3 étant à l'intérieur du double vitrage.

De la même manière, un triple vitrage comporte 6 faces, la face 1 est à l'extérieur du bâtiment (paroi extérieure du vitrage), la face 6 à l'intérieur du bâtiment (paroi intérieure du vitrage) et les faces 2 à 5 sont à l'intérieur du triple vitrage.

Un vitrage feuilleté comporte au moins une structure de type premier substrat / feuille(s) / deuxième substrat. L'empilement de couches minces est positionné sur l'une au moins des faces d'un des substrats. L'empilement peut être sur la face du deuxième substrat non au contact de la feuille, de préférence polymère. Ce mode de réalisation est avantageux lorsque le vitrage feuilleté est monté en double vitrage avec un troisième substrat.

Le vitrage selon l'invention, utilisé comme vitrage monolithique ou dans un vitrage multiple de type double-vitrage, présente des couleurs en réflexion extérieure neutres, agréables et douces, dans la gamme des bleus ou bleus-verts (valeurs de longueur d'onde dominante de l'ordre de 470 à 500 nanomètres). De plus, cet aspect visuel reste quasiment inchangé quel que soit l'angle d'incidence avec lequel le vitrage est observé (incidence normale et sous angle). Cela signifie qu'un observateur n'a pas l'impression d'une inhomogénéité significative de teinte ou d'aspect.

Par « couleur dans le bleu-vert » au sens de la présente invention, il faut comprendre que dans le système de mesure de couleur L*a*b*, a* est compris entre - 10,0 et 0,0, de préférence entre -5,0 et 0,0 et b* est compris entre -10,0 et 0,0, de préférence entre -5,0 et 0,0.

Le vitrage de l'invention présente des couleurs en réflexion côté extérieur dans le système de mesure de couleur L*a*b* :
- a* compris entre -5,0 et 0,0, de préférence entre -4,0 et 0,0 et/ou
- b* est compris entre -6,0 et 0,0, de préférence entre -5,0 et -1,0.

Le vitrage de l'invention présente des couleurs en transmission dans le système de mesure de couleur L*a*b* avec a* compris entre -6,0 et 0,0, de préférence entre - 5,0 et 0,0.

Selon des modes de réalisation avantageux, le vitrage de l'invention sous forme d'un double vitrage comprenant l'empilement positionné en face 2 permet d'atteindre notamment les performances suivantes :
- un facteur solaire g inférieur ou égal à 27,5 %, de préférence inférieur ou égal à 25,0 %, et/ou
- une transmission lumineuse inférieure à 60,0 %, de préférence comprise entre 40,0 % et 60,0 %, voire comprise entre 45,0 et 55,0 % et/ou
- une sélectivité élevée, de préférence d'au moins 1,8, d'au moins 1,9 et mieux d'au moins 2,0, et/ou
- une faible émissivité, notamment inférieure à 1 %, et/ou
- une réflexion lumineuse côté extérieur, par ordre de préférence croissant, supérieure ou égale à 20,0 %, supérieure ou égale à 25,0 %, supérieure ou égale à 27,5 %, voire supérieure ou égale à 30,0 %, et/ou
- des couleurs neutres en réflexion extérieure.

Les détails et caractéristiques avantageuses de l'invention ressortent des exemples non limitatifs suivants, illustrés à l'aide de la figure jointe.

Les proportions entre les différents éléments ne sont pas respectées afin de faciliter la lecture des figures.

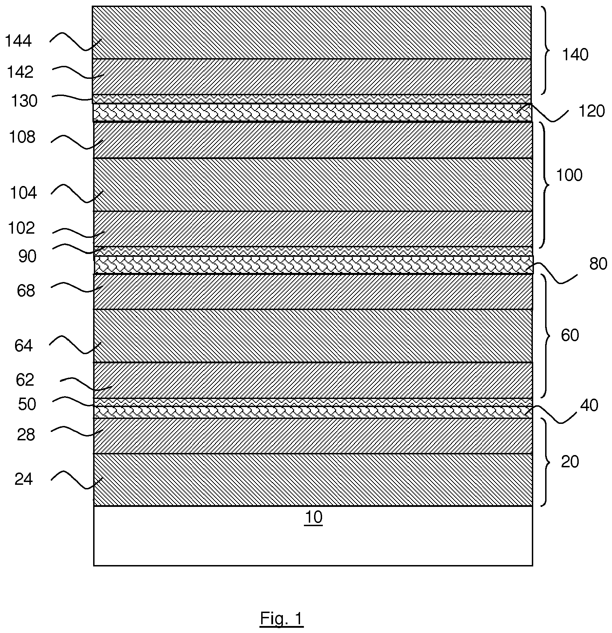

La figure 1 illustre une structure d'empilement à trois couches métalliques fonctionnelles 40, 80, 120, cette structure étant déposée sur un substrat 10 verrier, transparent. Chaque couche fonctionnelle 40, 80, 120 est disposée entre deux revêtements diélectrique 20, 60, 100, 140 de telle sorte que :
- la première couche fonctionnelle 40 en partant du substrat est disposée entre les revêtements diélectrique 20, 60,
- la deuxième couche fonctionnelle 80 est disposée entre les revêtements diélectrique 60, 100 et
- la troisième couche fonctionnelle 120 est disposée entre les revêtements diélectriques 100, 140.

Ces revêtements diélectriques 20, 60, 100, 140 comportent chacun au moins une couche diélectrique 24, 28 ; 62, 64, 68 ; 102, 104, 108 ; 142, 144.

L'empilement peut comprendre également :
- des sous-couches de blocage 30, 70, et 110 (non représentées), situées au contact d'une couche fonctionnelle,
- des surcouches de blocage 50, 90 et 130 situées au contact d'une couche fonctionnelle,
- une couche de protection 160 (non représentée).

### Exemples

### I. Préparation des substrats : Empilements, conditions de dépôt et traitements thermiques

Des empilements de couches minces définis ci-après sont déposés sur des substrats en verre sodo-calcique clair d'une épaisseur de 6 mm.

Dans les exemples de l'invention :
- les couches fonctionnelles sont des couches d'argent (Ag),
- les couches de blocage sont des couches métalliques en alliage de nickel et de chrome (NiCr),
- les couches barrières sont à base de nitrure de silicium, dopé à l'aluminium (Si₃N₄ : Al),
- les couches stabilisantes sont en oxyde de zinc dopé aluminium (ZnO).

Les conditions de dépôt des couches, qui ont été déposées par pulvérisation (pulvérisation dite « cathodique magnétron »), sont résumées dans le tableau 1.

| **Tab. 1** | Cible employée | Pression de dépôt | Gaz | n 550 nm |
|---|---|---|---|---|
| Si₃N₄ | Si:Al à 92:8 % en poids | 3,2.10-3 mbar | Ar /(Ar + N2) à 55 % | 2,03 |
| ZnO | Zn:Al à 98:2 % en poids | 1,8.10-3 mbar | Ar /(Ar + O2) à 63 % | 1,95 |
| TiZrO | TiZrOx | 2-4*10⁻³ mbar | Ar 90 % - O₂ 10 % | 2,32 |
| NiCr | Ni (80% at.) : Cr (20% at.) | 2-3.10⁻³ mbar | Ar à 100 % | - |
| Ag | Ag | 3.10-3 mbar | Ar à 100 % | - |

| | | | | |
|---|---|---|---|---|
| At. = atomique | | | | |

Le tableau 2 liste les matériaux et les épaisseurs physiques en nanomètres (sauf autre indication) de chaque couche ou revêtement qui constitue les empilements en fonction de leur position vis-à-vis du substrat porteur de l'empilement (dernière ligne en bas du tableau). Les numéros « Réf. » correspondent aux références de la figure 1.

| **Tab. 2** | **Réf.** | **Inv.1** | **Inv.2** | **Inv.3** |
|---|---|---|---|---|
| Revêtement diélectrique M4 | 140 | 43 | 42 | 50 |
| - TiZrOx | 160 | 2 | 2 | 2 |
| - Si₃N₄ | 144 | 33 | 32 | 40 |
| - ZnO | 142 | 8 | 8 | 8 |
| Couche blocage NiCr | 130 | 0,1 | 0,1 | 0,4 |
| Couche fonctionnelle Ag3 | 120 | 15,5 | 15,4 | 14 |
| Couche blocage NiCr | 110 | 0 | 0 | 0,3 |
| Revêtement diélectrique M3 | 100 | 84 | 82 | 98 |
| - ZnO | 108 | 8 | 8 | 8 |
| - Si₃N₄ | 104 | 68 | 66 | 82 |
| - ZnO | 102 | 8 | 8 | 8 |
| Couche blocage NiCr | 90 | 0,6 | 0,6 | 0,2 |
| Couche fonctionnelle Ag2 | 80 | 15,8 | 15,6 | 15,5 |
| Couche blocage NiCr | 70 | 0 | 0 | 0,1 |
| Revêtement diélectrique M2 | 60 | 56 | 55 | 67 |
| - ZnO | 68 | 8 | 8 | 8 |
| - Si₃N₄ | 64 | 40 | 39 | 51 |
| - ZnO | 62 | 8 | 8 | 8 |
| Couche blocage NiCr | 50 | 0,1 | 0,1 | 0,1 |
| Couche fonctionnelle Ag1 | 40 | 7 | 7 | 7 |
| Couche blocage NiCr | 30 | 0 | 0 | 0,1 |
| Revêtement diélectrique M1 | 20 | 56 | 57 | 66 |
| - ZnO | 28 | 8 | 8 | 8 |
| - Si₃N₄ | 24 | 48 | 49 | 58 |
| Substrat verre (mm) | 10 | 6 | 6 | 6 |

Chaque revêtement diélectrique 20, 60, 100 en-dessous d'une couche fonctionnelle 40, 80, 120 comporte une dernière couche stabilisante 28, 68, 108 à base d'oxyde de zinc cristallisé, et qui est au contact de la couche fonctionnelle 40, 80, 120 déposée juste au-dessus.

Chaque revêtement diélectrique 60, 100, 140 au-dessus d'une couche fonctionnelle 40, 80, 120 comporte une première couche stabilisante 62, 102, 142 à base d'oxyde de zinc cristallisé, et qui est au contact de la couche fonctionnelle 40, 80, 120 déposée juste au-dessus.

Chaque revêtement diélectrique 20, 60, 100, 140 comporte une couche diélectrique à fonction barrière 24, 64, 104, 144, à base de nitrure de silicium, dopé à l'aluminium appelée ici Si₃N₄.

Chaque couche fonctionnelle métallique 40, 80, 120 est en-dessous et au contact d'une couche de blocage 50, 90 et 130.

Chaque couche fonctionnelle métallique 40, 80, 120 peut être au-dessus d'une couche de blocage 30, 70 et 110 (non représentées sur la figure 1).

L'empilement comprend en outre une couche de protection en oxyde de titane et de zirconium 160 (non représentée sur la figure 1).

Le tableau 3 résume les caractéristiques liées aux épaisseurs des couches fonctionnelles et des revêtements diélectriques.

| **Tab. 3** | **Inv.1** | | **Inv.2** | | **Inv.3** | |
|---|---|---|---|---|---|---|
| Revêtement diélectrique | Ep | Eo | Ep | Eo | Ep | Eo |
| M1 | 56 | 113,04 | 57 | 115,07 | 66 | 133,34 |
| M2 | 56 | 112,4 | 55 | 110,37 | 67 | 134,73 |
| M3 | 84 | 169,24 | 82 | 165,18 | 98 | 197,66 |
| M4 | 43 | 87,23 | 42 | 85,2 | 50 | 101,44 |
| 1,1*Eo1 | 124,34 | | 126,58 | | 146,67 | |
| Eo2 < 1,1*Eo1 | Oui | | Oui | | Oui | |
| Ag1 < Ag2 et Ag3 | Oui | | Oui | | Oui | |
| Ag3/Ag2 | 0,98 | | 0,99 | | 0,90 | |

| | | | | | | |
|---|---|---|---|---|---|---|
| Ep : Epaisseur physique (nm) ; Eo : Epaisseur optique (nm). | | | | | | |

### II. Performances « contrôle solaire » et colorimétrie

Le tableau 4 liste les principales caractéristiques optiques mesurées lorsque les vitrages font parties de double vitrage de structure 6/16/4 : verre de 6 mm / espace intercalaire de 16 mm rempli d'argon à 90 % / verre de 4 mm, l'empilement étant positionné en face 2 (la face 1 du vitrage étant la face la plus à l'extérieur du vitrage, comme habituellement).

Pour ces doubles vitrages,
- TL indique : la transmission lumineuse dans le visible en %, mesurée selon l'illuminant D65 à 2° Observateur ;
- a*T et b*T indiquent les couleurs en transmission a* et b* dans le système L*a*b* mesurées selon l'illuminant D65 à 2° Observateur et mesurées perpendiculairement au vitrage ;
- RLext indique : la réflexion lumineuse dans le visible en %, mesurée selon l'illuminant D65 à 2° Observateur du côté de la face la plus à l'extérieur, la face 1 ;
- a*Rext et b*Rext indiquent les couleurs en réflexion a* et b* dans le système L*a*b* mesurées selon l'illuminant D65 à 2° Observateur du côté de la face la plus à l'extérieur et mesurées ainsi perpendiculairement au vitrage,
- RLint indique : la réflexion lumineuse dans le visible en %, mesurée selon l'illuminant D65 à 2° Observateur du côté de la face intérieur, la face 4 ;
- a*Rint et b*Rint indiquent les couleurs en réflexion a* et b* dans le système L*a*b* mesurées selon l'illuminant D65 à 2° Observateur du côté de la face intérieur et mesurées ainsi perpendiculairement au vitrage.

Les valeurs colorimétriques en angle a*g60° et b*g60° sont mesurées sur simple vitrage sous incidence de 60°. Cela rend compte de la neutralité des couleurs en angle.

| **Tab. 4** | **Valeur cible** | **Inv.1** | **Inv.2** | **Inv.3** |
|---|---|---|---|---|
| Facteurs solaire « g » | ≤ 27,5 % | 25 % | 25 % | 25 % |
| Sélectivité « s » | > 1,8 | 2,0 | 2,0 | 2,0 |
| TL% | ≈ 50 % | 50 | 50 | 50 |
| - a*T | <0 | -5,0 | -4,9 | -1,7 |
| - b*T | - | 4,5 | 3,0 | 2,5 |
| RLext% | >25 | 30 | 30 | 30 |
| - a*Rext | <0 | -1,0 | -1,0 | -3,4 |
| - b*Rext | <0 | -4,0 | -2,0 | -3,2 |
| RLint% | - | 26 | 25 | 29 |
| - a*Rint | <0 | -4,0 | -4,0 | -1,7 |
| - b*Rint | <0 | -6,4 | -4,7 | -4,2 |
| - a*g60° | - | -4,0 | -4,0 | -4,2 |
| - b*g60° | - | -4,4 | -3,1 | -2,4 |

Selon l'invention, il est possible de réaliser un vitrage comprenant un empilement à trois couches fonctionnelles métalliques qui présente un aspect argent brillant en réflexion côté extérieur, une transmission lumineuse d'environ 50 %, une sélectivité élevée, une réflexion lumineuse élevée et un facteur solaire faible.

Les exemples selon l'invention présentent tous une coloration en transmission agréable et douce, de préférence dans la gamme des bleus ou bleus-verts.

Les vitrages selon l'invention présentent à la fois un facteur solaire inférieur ou égal à 25 % et une sélectivité supérieure à 1,80. Ces vitrages présentent en plus une réflexion extérieure au moins supérieure à 25 %, voire inférieure à 27,5 %. Ces vitrages ont également des couleurs en transmission neutres.

## Revendications

1. Matériau comprenant un substrat transparent revêtu d'un empilement de couches minces comportant successivement à partir du substrat en une alternance de seulement trois couches métalliques fonctionnelles à base d'argent dénommées en partant du substrat première, deuxième et troisième couches fonctionnelles et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, **caractérisé en ce que** :
- l'épaisseur de la première couche fonctionnelle est inférieure à l'épaisseur de la deuxième couche fonctionnelle,
- l'épaisseur de la première couche fonctionnelle est inférieure à l'épaisseur de la troisième couche fonctionnelle,
- l'épaisseur de la troisième couche métallique fonctionnelle est comprise entre 13 et 18 nm,
- les revêtements diélectriques M1 et M2 ont chacun une épaisseur optique Eo1 et Eo2 satisfaisant la relation suivante : Eo2 < 1,1 Eo1,
le matériau présente une transmission lumineuse inférieure à 60,0 % et une réflexion lumineuse côté extérieur supérieure ou égale à 20,0 %.

2. Matériau selon la revendication 1 **caractérisé en ce que** le rapport de l'épaisseur de la troisième couche métallique fonctionnelle sur l'épaisseur de la deuxième couche fonctionnelle est compris entre 0,90 et 1,10 en incluant ces valeurs.

3. Matériau selon l'une des revendications précédentes, **caractérisé en ce que** les trois couches métalliques fonctionnelles satisfont les caractéristiques suivantes :
- l'épaisseur de la première couche métallique fonctionnelle est comprise entre 6 et 12 nm,
- l'épaisseur de la deuxième couche métallique fonctionnelle est comprise entre 13 et 20 nm,
- l'épaisseur de la troisième couche métallique fonctionnelle est comprise entre 13 et 18 nm.

4. Matériau selon l'une quelconque des revendications précédentes, **caractérisé en ce que** l'empilement comprend en outre au moins une couche de blocage située au contact d'une couche fonctionnelle choisies parmi les couches métalliques à base d'un métal ou d'un alliage métallique, les couches de nitrure métallique, les couches d'oxyde métallique et les couches d'oxynitrure métallique d'un ou plusieurs éléments choisis parmi le titane, le nickel, le chrome et le niobium telles qu'une couche de Ti, TiN, TiOx, Nb, NbN, Ni, NiN, Cr, CrN, NiCr, NiCrN.

5. Matériau selon la revendication précédente, **caractérisé en ce que** l'épaisseur totale de toutes les couches de blocage au contact des couches fonctionnelles est comprise entre 0,1 et 2 nm en incluant ces valeurs.

6. Matériau selon l'une des revendications précédentes, **caractérisé en ce que** les revêtements diélectriques satisfont les caractéristiques suivantes :
- l'épaisseur optique du premier revêtement diélectrique M1 est comprise de 85 à 150 nm,
- l'épaisseur optique du deuxième revêtement diélectrique M2 est comprise de 80 à 150 nm,
- l'épaisseur optique du troisième revêtement diélectrique M3 est comprise de 135 à 220 nm,
- l'épaisseur optique du quatrième revêtement diélectrique M4 est comprise de 65 à 120 nm.

7. Matériau selon l'une quelconque des revendications précédentes, **caractérisé en ce que** chaque des revêtements diélectrique comporte au moins une couche diélectrique à fonction barrière à base de composés de silicium et/ou d'aluminium choisis parmi les oxydes tels que SiO₂ et Al₂O₃, les nitrures de silicium Si₃N₄ et AIN et les oxynitures SiOₓN_{y} et AlOₓN_{y}.

8. Matériau selon l'une quelconque des revendications précédentes, **caractérisé en ce que** chaque revêtement diélectrique comporte au moins une couche diélectrique à fonction stabilisante à base d'oxyde cristallisé, notamment à base d'oxyde de zinc, éventuellement dopé à l'aide d'au moins un autre élément, comme l'aluminium.

9. Matériau selon l'une quelconque des revendications précédentes, **caractérisé en ce que** chaque couche fonctionnelle est au-dessus d'un revêtement diélectrique dont la couche supérieure est une couche diélectrique à fonction stabilisante, de préférence à base d'oxyde de zinc et/ou en-dessous d'un revêtement diélectrique dont la couche inférieure est une couche diélectrique à fonction stabilisante, de préférence à base d'oxyde de zinc.

10. Matériau selon l'une quelconque des revendications précédentes **caractérisé en ce qu'**il comprend un empilement défini en partant du substrat transparent comprenant :
- un premier revêtement diélectrique comprenant au moins une couche diélectrique à fonction barrière et une couche diélectrique à fonction stabilisante,
- éventuellement une couche de blocage,
- une première couche fonctionnelle,
- éventuellement une couche de blocage,
- un deuxième revêtement diélectrique comprenant au moins une couche diélectrique à fonction stabilisante inférieure, une couche diélectrique à fonction barrière et une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins une couche diélectrique à fonction stabilisante inférieure, une couche diélectrique à fonction barrière et une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante, une couche diélectrique à fonction barrière et éventuellement une couche de protection.

11. Procédé d'obtention d'un matériau selon l'une des revendications précédentes, dans lequel on dépose les couches de l'empilement par pulvérisation cathodique magnétron.

12. Vitrage comprenant au moins un matériau selon l'une des revendications 1 à 10 précédentes.

13. Vitrage selon la revendication précédente **caractérisé en ce que** l'empilement est positionné dans le vitrage de sorte que la lumière incidente provenant de l'extérieur traverse le premier revêtement diélectrique avant de traverser la première couche métallique fonctionnelle.

14. Vitrage selon l'une quelconque des revendications 12 ou 13, caractérisé en qu'il est sous forme de vitrage monolithique, feuilleté ou multiple, en particulier double vitrage ou triple vitrage.

15. Vitrage selon l'une quelconque des revendications 12 à 14, **caractérisé en ce qu'**il est sous forme d'un double vitrage comprenant l'empilement positionné en face 2 et présente une réflexion lumineuse côté extérieur supérieure ou égale à 25,0.

## Patentansprüche

1. Material, umfassend ein transparentes Substrat, das mit einer Stapelung von Dünnschichten beschichtet ist, aufweisend vom Substrat ausgehend nacheinander eine Abfolge von drei funktionellen Metallschichten auf Basis von Silber, die von dem Substrat beginnend als erste, zweite und dritte funktionelle Schicht bezeichnet werden, und vier dielektrische Beschichtungen, die von dem Substrat beginnend als M1, M2, M3 und M4 bezeichnet werden, wobei jede dielektrische Beschichtung mindestens eine dielektrische Schicht aufweist, sodass jede funktionelle Metallschicht zwischen zwei dielektrischen Beschichtungen angeordnet ist, **dadurch gekennzeichnet, dass:**
- die Dicke der ersten funktionellen Schicht geringer als die Dicke der zweiten funktionellen Schicht ist,
- die Dicke der ersten funktionellen Schicht geringer als die Dicke der dritten funktionellen Schicht ist,
- die Dicke der dritten funktionellen Metallschicht zwischen 13 und 18 nm liegt,
- die dielektrischen Beschichtungen M1 und M2 jeweils eine optische Dicke Eo1 und Eo2 aufweisen, die der folgenden Beziehung genügen: Eo2 < 1,1 Eo1,
wobei das Material eine Lichtdurchlässigkeit geringer als 60,0 % und eine außenseitige Lichtreflexion größer als oder gleich 20,0 % vorweist.

2. Material nach Anspruch 1, **dadurch gekennzeichnet, dass** das Verhältnis der Dicke der dritten funktionellen Metallschicht zu der Dicke der zweiten funktionellen Schicht zwischen 0,90 und 1,10 einschließlich dieser Werte liegt.

3. Material nach einem der vorstehenden Ansprüche,
**dadurch gekennzeichnet, dass** die drei funktionellen Metallschichten den folgenden Eigenschaften genügen:
- die Dicke der ersten funktionellen Metallschicht liegt zwischen 6 und 12 nm,
- die Dicke der zweiten funktionellen Metallschicht liegt zwischen 13 und 20 nm,
- die Dicke der dritten funktionellen Metallschicht liegt zwischen 13 und 18 nm.

4. Material nach einem der vorstehenden Ansprüche,
**dadurch gekennzeichnet, dass** die Stapelung ferner mindestens eine Blockierschicht umfasst, die sich in Kontakt mit einer funktionellen Metallschicht befindet, ausgewählt aus den Metallschichten auf Basis eines Metalls oder einer Metalllegierung, Metallnitridschichten, Metalloxidschichten und Metalloxynitridschichten aus einem oder mehreren Elementen, ausgewählt aus Titan, Nickel, Chrom und Niob, wie eine Schicht aus Ti, TiN, TiOx, Nb, NbN, Ni, NiN, Cr, CrN, NiCr, NiCrN.

5. Material nach dem vorstehenden Anspruch,
**dadurch gekennzeichnet, dass** die Gesamtdicke sämtlicher der Blockierschichten, die mit den funktionellen Schichten in Kontakt stehen, zwischen 0,1 und 2 nm einschließlich dieser Werte liegt.

6. Material nach einem der vorstehenden Ansprüche,
**dadurch gekennzeichnet, dass** die dielektrischen Beschichtungen den folgenden Eigenschaften genügen:
- die optische Dicke der ersten dielektrischen Beschichtung M1 beträgt von 85 bis 150 nm,
- die optische Dicke der zweiten dielektrischen Beschichtung M2 beträgt von 80 bis 150 nm,
- die optische Dicke der dritten dielektrischen Beschichtung M3 beträgt von 135 bis 220 nm,
- die optische Dicke der vierten dielektrischen Beschichtung M4 beträgt von 65 bis 120 nm.

7. Material nach einem der vorstehenden Ansprüche,
**dadurch gekennzeichnet, dass** jede dielektrische Beschichtung mindestens eine dielektrische Schicht mit Barrierefunktion auf Basis von Silicium- und/oder Aluminiumverbindungen, ausgewählt aus den Oxiden wie SiO₂ und Al₂O₃, Siliciumnitriden Si₃N₄ und AIN und Oxynitriden SiOₓN_{y} und AlOₓN_{y}, aufweist.

8. Material nach einem der vorstehenden Ansprüche,
**dadurch gekennzeichnet, dass** jede dielektrische Beschichtung mindestens eine dielektrische Schicht mit Stabilisierungsfunktion auf Basis von kristallisiertem Oxid, insbesondere auf Basis von Zinkoxid, gegebenenfalls mithilfe mindestens eines anderen Elements wie Aluminium dotiert, aufweist.

9. Material nach einem der vorstehenden Ansprüche,
**dadurch gekennzeichnet, dass** jede funktionelle Schicht oberhalb einer dielektrischen Beschichtung, deren obere Schicht eine dielektrische Schicht mit stabilisierender Funktion, vorzugsweise auf Basis von Zinkoxid, ist, und/oder unterhalb einer dielektrischen Beschichtung liegt, deren untere Schicht eine dielektrische Schicht mit stabilisierender Funktion, vorzugsweise auf Basis von Zinkoxid, ist.

10. Material nach einem der vorstehenden Ansprüche,
**dadurch gekennzeichnet, dass** es eine von dem transparenten Substrat beginnende definierte Stapelung umfasst, umfassend:
- eine erste dielektrische Beschichtung, die mindestens eine dielektrische Schicht mit Barrierefunktion und eine dielektrische Schicht mit Stabilisierungsfunktion umfasst,
- gegebenenfalls eine Blockierschicht,
- eine erste funktionelle Schicht,
- gegebenenfalls eine Blockierschicht,
- eine zweite dielektrische Beschichtung, die mindestens eine untere dielektrische Schicht mit Stabilisierungsfunktion, eine dielektrische Schicht mit Barrierefunktion und eine obere dielektrische Schicht mit Stabilisierungsfunktion umfasst,
- gegebenenfalls eine Blockierschicht,
- eine zweite funktionelle Schicht,
- gegebenenfalls eine Blockierschicht,
- eine dritte dielektrische Beschichtung, die mindestens eine untere dielektrische Schicht mit Stabilisierungsfunktion, eine dielektrische Schicht mit Barrierefunktion und eine obere dielektrische Schicht mit Stabilisierungsfunktion umfasst,
- gegebenenfalls eine Blockierschicht,
- eine dritte funktionelle Schicht,
- gegebenenfalls eine Blockierschicht,
- eine vierte dielektrische Beschichtung, die mindestens eine dielektrische Schicht mit Stabilisierungsfunktion, eine dielektrische Schicht mit Barrierefunktion und gegebenenfalls eine Schutzschicht umfasst.

11. Verfahren zum Erhalten eines Materials nach einem der vorstehenden Ansprüche, wobei die Schichten der Stapelung durch Magnetron-Kathodenzerstäubung abgeschieden werden.

12. Verglasung, die mindestens ein Material nach einem der vorstehenden Ansprüche 1 bis 10 umfasst.

13. Verglasung nach dem vorstehenden Anspruch,
**dadurch gekennzeichnet, dass** die Stapelung in der Verglasung positioniert ist, sodass das von außen stammende einfallende Licht vor dem Durchqueren der ersten funktionellen Metallschicht die erste dielektrische Beschichtung durchquert.

14. Verglasung nach einem der Ansprüche 12 oder 13,
**dadurch gekennzeichnet, dass** sie in Form von Einscheiben-, Verbund- oder Mehrfachverglasung, besonders Doppel- oder Dreifachverglasung, vorliegt.

15. Verglasung nach einem der Ansprüche 12 bis 14,
**dadurch gekennzeichnet, dass** sie in Form einer Doppelverglasung vorliegt, die auf der Seite 2 positioniert ist und eine außenseitige Lichtreflexion größer als oder gleich 25,0 vorweist.

## Claims

1. A material comprising a transparent substrate coated with a stack of thin layers successively comprising, starting from the substrate, an alternation of only three silver-based functional metallic layers referred to, starting from the substrate, as first, second and third functional layers and of four dielectric coatings, referred to, starting from the substrate, as M1, M2, M3 and M4, each dielectric coating comprising at least one dielectric layer, so that each functional metallic layer is positioned between two dielectric coatings, **characterized in that**:
- the thickness of the first functional layer is less than the thickness of the second functional layer,
- the thickness of the first functional layer is less than the thickness of the third functional layer,
- the thickness of the third functional metallic layer is between 13 and 18 nm,
- the dielectric coatings M1 and M2 each have an optical thickness Eo1 and Eo2 satisfying the following equation: Eo2 < 1.1 Eo1,
the has a light transmission of less than 60.0% and a light reflection on the external side of greater than or equal to 20.0%.

2. The material as claimed in claim 1, **characterized in that** the ratio of the thickness of the third functional metallic layer to the thickness of the second functional layer is between 0.90 and 1.10, including these values.

3. The material as claimed in either of the preceding claims, **characterized in that** the three functional metallic layers satisfy the following characteristics:
- the thickness of the first functional metallic layer is between 6 and 12 nm,
- the thickness of the second functional metallic layer is between 13 and 20 nm,
- the thickness of the third functional metallic layer is between 13 and 18 nm.

4. The material as claimed in any one of the preceding claims, **characterized in that** the stack also comprises at least one blocking layer located in contact with a functional layer selected from metallic layers based on a metal or on a metal alloy, metal nitride layers, metal oxide layers and metal oxynitride layers of one or more elements selected from titanium, nickel, chromium and niobium, such as a Ti, TiN, TiOx, Nb, NbN, Ni, NiN, Cr, CrN, NiCr or NiCrN layer.

5. The material as claimed in the preceding claim, **characterized in that** the total thickness of all the blocking layers in contact with the functional layers is between 0.1 and 2 nm, including these values.

6. The material as claimed in one of the preceding claims, **characterized in that** the dielectric coatings satisfy the following characteristics:
- the optical thickness of the first dielectric coating M1 is from 85 to 150 nm,
- the optical thickness of the second dielectric coating M2 is from 80 to 150 nm,
- the optical thickness of the third dielectric coating M3 is from 135 to 220 nm,
- the optical thickness of the fourth dielectric coating M4 is from 65 to 120 nm.

7. The material as claimed in any one of the preceding claims, **characterized in that** each of the dielectric coatings comprises at least one dielectric layer having a barrier function based on silicon and/or aluminum compounds selected from oxides such as SiOz and Al₂O₃, silicon nitrides Si₃N₄ and AIN and oxynitrides SiOₓN_{y} and AlOₓN_{y}.

8. The material as claimed in any one of the preceding claims, **characterized in that** each dielectric coating comprises at least one dielectric layer having a stabilizing function based on a crystalline oxide, in particular based on zinc oxide, optionally doped with the aid of at least one other element, such as aluminum.

9. The material as claimed in any one of the preceding claims, **characterized in that** each functional layer is on top of a dielectric coating, the upper layer of which is a dielectric layer having a stabilizing function, preferably based on zinc oxide and/or underneath a dielectric coating, the lower layer of which is a dielectric layer having a stabilizing function, preferably based on zinc oxide.

10. The material as claimed in any one of the preceding claims, **characterized in that** it comprises a stack, defined starting from the transparent substrate, comprising:
- a first dielectric coating comprising at least one dielectric layer having a barrier function and one dielectric layer having a stabilizing function,
- optionally a blocking layer,
- a first functional layer,
- optionally a blocking layer,
- a second dielectric coating comprising at least one lower dielectric layer having a stabilizing function, one dielectric layer having a barrier function and one upper dielectric layer having a stabilizing function,
- optionally a blocking layer,
- a second functional layer,
- optionally a blocking layer,
- a third dielectric coating comprising at least one lower dielectric layer having a stabilizing function, one dielectric layer having a barrier function and one upper dielectric layer having a stabilizing function,
- optionally a blocking layer,
- a third functional layer,
- optionally a blocking layer,
- a fourth dielectric coating comprising at least one dielectric layer having a stabilizing function, one dielectric layer having a barrier function and optionally one protective layer.

11. A process for obtaining a material as claimed in one of the preceding claims, wherein the layers of the stack are deposited by magnetron sputtering.

12. A glazing comprising at least one material as claimed in one of the preceding claims 1 to 10.

13. The glazing as claimed in the preceding claim, **characterized in that** the stack is positioned in the glazing so that the incident light coming from outside passes through the first dielectric coating before passing through the first functional metallic layer.

14. The glazing as claimed in either one of claims 12 and 13, **characterized in that** it is in the form of monolithic, laminated or multiple glazing, in particular double glazing or triple glazing.

15. The glazing as claimed in either one of claims 12 to 14, **characterized in that** it is in the form of double glazing comprising the stack located on face 2 and has d a light reflection on the external side of greater than or equal to 25.0%.
